Europäisches Patentamt

European Patent Office

Office européen des brevets

(11) Publication number: **0 056 093**
**B1**

(12) # EUROPEAN PATENT SPECIFICATION

(45) Date of publication of patent specification: **11.03.87**

(51) Int. Cl.⁴: **H 05 K 3/42, H 05 K 3/18**

(21) Application number: **81109013.3**

(22) Date of filing: **27.10.81**

(54) **Process for producing a printed circuit board.**

(30) Priority: **09.01.81 JP 1044/81**

(43) Date of publication of application:
**21.07.82 Bulletin 82/29**

(45) Publication of the grant of the patent:
**11.03.87 Bulletin 87/11**

(84) Designated Contracting States:
**DE FR GB NL**

(56) References cited:
**FR-A-2 149 170**
**FR-A-2 253 229**

(73) Proprietor: **Kabushiki Kaisha Toshiba**
**72, Horikawa-cho Saiwai-ku**
**Kawasaki-shi Kanagawa-ken 210 (JP)**

(72) Inventor: **Takahashi, Katsuhiro**
**40, Naka Shinden Nabekura**
**Hanamaki-shi Iwate-ken (JP)**
Inventor: **Ikari, Kunihiro**
**3-10, Mabori-kaigan 2-chome**
**Yokosuka-shi Kanagawa-ken (JP)**

(74) Representative: **Lehn, Werner, Dipl.-Ing. et al**
**Hoffmann, Eitle & Partner Patentanwälte**
**Arabellastrasse 4 (Sternhaus)**
**D-8000 München 81 (DE)**

Courier Press, Leamington Spa, England.

# 0 056 093

## Description

The present invention relates to a process for producing a printed circuit board, and particularly to an improvement of a process for producing a printed circuit board wherein a conductive circuit is directly formed on an insulating substrate by non-electrolytic plating.

In recent years, there has been developed an art for producing a printed circuit board by directly and selectively depositing catalytically active metal particles on a substrate by a photochemical reaction and then immersing the substrate in a non-electrolytic plating solution to form a circuit conductor only at portions where the metal particles are precipitated (this art will hereinafter be referred to as "photo-forming"), without using a copper clad laminated board, an etching resist, a plating resist or a catalyst-containing substrate.

This photo-forming method comprises forming on the entire insulating substrate having a through hole, a light sensitive material layer which contains a metal capable of constituting catalytic nuclei for non-electrolytic plating, in a reducible oxidized state and a light sensitive substance (i.e. a light sensitive reducing agent) capable of forming a reducing agent upon absorption of radiant energy, then selectively exposing portions expected to form a circuit, thereby to reductively precipitate metal particles which are catalytically active for the non-electrolytic plating, and then immersing thus treated substrate in a non electrolytic plating solution to form a circuit conductor on the portion where the metal particles are precipitated (U.S. Patent No. 3,772,078).

A typical example of this method will be described as follows:

a) An insulating substrate having a through hole is coated on its surface and on the inner wall surface of the through hole, with an aqueous light sensitive solution containing a light sensitive reducing agent composition (such as a copper salt) and a surface active agent, and then dried.

b) A negative film is directly overlaid on this substrate, and exposure is conducted by a ultraviolet ray thereby to precipitate metal particles such as copper, which constitute catalytic nuclei for plating.

c) After removing the negative film, non-reacted light sensitive material remaining on the surface of the substrate is washed off with water.

d) The substrate is immersed in a non-electrolytic plating solution and plating copper is precipitated on the metal particles, whereby a conductor circuit is obtained.

A similar method for fabricating a printed circuit board is disclosed in U.S. Patent No. 4 085 285 but in which the use of a light sensitive reducing agent is omitted. Another step is included instead, which involves the depositing of fine particles of a light sensitive metal oxide semiconductor on at least the inner wall surface of a through hole.

In the production of a printed circuit board by such photo-forming methods, there is a drawback that non-plated fine portions (hereinafter referred to as "plating voids") will be left on the inner surface of the through hole, and the reliability of the electric connection of the through hole will thereby be impaired, although there is no problem for the formation of the circuit on the flat surface of the substrate.

The present invention is intended to eliminate such a drawback inherent to the conventional photo-forming method, and it is an object of the present invention to provide a process for producing a printed circuit board, whereby it is possible to effectively carry out the formation of a circuit at the through hole portion, thereby ensuring the reliability of the electric connection of the through hole portion of the circuit board.

From a study of the cause for the formation of plating voids at the through hole portion in the production of a printed circuit board according to the conventional photo-forming method, it has been found that the formation of plating voids are based on the following cause. Namely, even when a light is radiated from both sides of the insulating substrate, no adequate light will reach the inside of a bore constituting the through hole which is a cylindrical pass-through bore, whereby the exposure will be inadequate and the precipitation of the metal particles will be insufficient. Thus, non-plated fine portions (i.e. plating voids) are likely to be left.

The present inventors have conducted extensive researches on the process for producing a printed circuit board by the photo-forming method comprising the above steps a) to d), whereupon it has been found that the above object can be attained by depositing fine particles of a light sensitive oxide semiconductor on the inner wall surface of the pass-through bore constituting the through hole, prior to the application of the aqueous light sensitive material solution. Thus, the present invention has been accomplished.

According to the present invention, there is provided a process for producing a printed circuit board, comprising;

A) a step of providing an adhesive layer on one side or both sides of an insulating substrates;

B) a step of roughening, and imparting a hydrophilic property to, the surface of said adhesive layer by a physical or chemical method;

D) a step of forming on the substrate a light sensitive material layer containing a metal in a reducible oxidized state capable of forming catalytic nuclei for non-electrolytic plating, and a light sensitive reducing agent;

E) a step of reductively precipitating metal particles constituting catalytic nuclei by selectively exposing said light sensitive material layer; and

2

F) a step of forming a conductor circuit layer by non-electrolytic plating after removing non-exposed portions of said light sensitive material layer;

wherein the improvement comprises providing between the step B) and the step D), a step C) of depositing fine particles of a light sensitive metal oxide semiconductor on at least the inner wall surface of a through hole.

As the insulating substrate which is used in the present invention, there may be mentioned a plastic plate, a ceramic plate, a laminated board containing a resin, or a metal plate coated on its surface with an insulating layer.

As the adhesive which is provided on the above-mentioned insulating substrate according to the present invention, there may be mentioned an adhesive comprising a polyester as the main component, an adhesive comprising an epoxy resin as the main component, an adhesive comprising a phenol resin as the main component, an adhesive comprising a polyvinyl acetate as the main component, and an adhesive comprising a diene type synthetic rubber as the main component. The adhesive comprising a diene type synthetic rubber as the main component is particularly desirable for the reason that a superior firm adhesion is thereby obtainable. As the adhesive containing such a diene type synthetic rubber, there are, for instance, a butadiene polymer, a butadiene-acrylonitrile copolymer, an isoprene rubber, a chloroprene rubber, an acrylonitrile-butadiene-styrene copolymer or a mixture of two or more of these substances, or a proper mixture of these substances with a thermosetting resin such as an epoxy resin or a phenol resin or a reinforcing material such as silica gel, zirconium silicate or magnesium silicate. Thus, in the case where the adhesives containing these diene type synthetic rubbers are employed, a high adhesion is given to the circuit layer which is important for a printed circuit. The adhesives are applied to predetermined portions of the substrate in a form of a solution, and hardened by heating.

The method for roughening and imparting a hydrophilic property to the surface of the adhesive layer thus formed, may be a chemical or physical method. As the chemical method, there may be mentioned, roughening by etching with use of an oxidizing agent such as chromic acid, a chromate, a permanganate, chromic acid-sulfuric acid, or chromic acid-sulfuric acid-phosphoric acid. The chromic acid-sulfuric acid system is particularly desirable for the reason that the plated layer thereby obtained will give a strong adhesion. Further, as the physical method, there may be mentioned, a mechanical roughening method such as a liquid honing or a blast method, a ultraviolet ray radiation method, etching by sputtering, a discharge treatment method such as corona, or a plasma treating method.

As the light sensitive metal oxide semiconductor to be used in the present invention, there may be mentioned, titanium dioxide ($TiO_2$), zinc oxide ($ZnO$), tin dioxide ($SnO_2$) or silica ($SiO_2$). In this case, the term "light sensitive" is meant in a broad sense for the sensitivity to a electromagnetic radiation such as a visible ray, a ultraviolet ray, a X-ray, or electron rays. It is assumed that the metal oxide semiconductor serves to catalytically assist the reaction of the light sensitive material which will be described hereinafter. Accordingly, the amount of its deposition may be very small and yet it is possible to facilitate the reaction of the light sensitive reducing agent to precipitate an adequate amount of metal catalytic nuclei even when the amount of light reaching the inner wall of the bore constituting the through hole is slight.

There are various possible methods to deposit the light sensitive metal oxide semiconductor on the inner wall of the bore constituting the through hole. However, a simple and practical method may be such that a powder of said semiconductor is dispersed in water to obtain a suspension, and the entire substrate is immersed in the suspension and then dried. At the time of dispersing it in water, a proper surface active agent may preferably be used. According to this method, a desirable phenomenon takes place such that during the process of drying after the immersing, the semiconductor powder deposits in a relatively thick state on the inner wall of the through hole or therearound. Further, the semiconductor powder deposits also on the entire surface of the substrate, and this does not bring about any problem.

The finer the powder of the light sensitive metal oxide semiconductor is, the more uniformly it can be deposited, and the better the dispersion and the floating condition become when it is dispersed to form a suspension. As such a semiconductor powder, there is, for instance, a commercially available powder having a particle size of about 0.03 to 0.5 μm, which is useful for the process of the present invention.

The amount of deposition of the light sensitive metal oxide semiconductor on the inner wall surface of the through hole may be very small. In the case where the substrate is immersed in the suspension as mentioned above, it will suffice to use a suspension wherein the semiconductor powder is dispersed in an amount of e.g. from 0.5 to 5 parts by weight into 100 parts by weight of water.

In the present invention, as the metal which is contained in the light sensitive material layer formed on the insulating substrate having deposited thereon the above-mentioned light sensitive oxide semiconductor and which is in a reducible oxidized state and serves as a catalyst for non-electrolytic plating, there may be used salts of gold, silver, platinum, palladium, copper, nickel, cobalt and iron. As the light sensitive reducing agent, there may be used aromatic diazo compounds, iron salts, anthraquinone derivatives, azido compounds, etc. Further, reduction facilitating agents, surface active agents or solvents such as pentaerythritol, or sorbitol, may properly be incorporated. The substrate is immersed in the above-mentioned light sensitive solution, and then dried to form a light sensitive material layer on the entire surface. Then, a ultraviolet ray is selectively radiated to this substrate with use of e.g. a negative film, to form plated catalytically active metal particles in a desired circuit pattern. The light source may be a diffusion type light source or a parallel light source. However, in a case of forming fine patterns, the parallel light source is desirable.

In the present invention, the non-electrolytic plating to form, by precipitation, a conductive circuit along the selectively exposed portion, is carried out by the use of, for instance, a non-electrolytic copper plating solution, a non-electrolytic nickel plating solution or a non-electrolytic gold plating solution. Thus, as the non-electrolytic plating solution, a non-electrolytic copper solution is suitable, and as its composition, there may be mentioned, for instance, a copper sulfate-ethylenediaminetetraacetic acid-formaldehyde system, or the same system suitably incorporated with sodium hydroxide, dipyridyl, or polyethylene oxide as the case requires. Further, as the plating conditions, it is usual that the bath temperature is from 50 to 78°C and a pH is from 12.0 to 13.0.

As described hereinabove, according to the present invention, in the production of a printed circuit board by a photo-forming method, fine particles of the light sensitive metal oxide semiconductor are deposited on the inner wall surface of the through hole, whereby the sensitivity of the light sensitive material layer formed on the inner wall of the bore constituting the through hole is increased, and accordingly the photochemical reaction can adequately be proceeded even with a small amount of exposure. This is due to the fact that upon exposure, the light sensitive oxide semiconductor is capable of reductively precipitating the metal contained in the light sensitive solution in an oxidized state. Thus, it is possible to adequately precipitate metal particles seving as a plating catalyst at the inner wall of the through hole, and to eliminate the formation of plating voids.

Thus, the process of the present invention may be said to be a process for producing a highly dependable printed circuit board superior in the reliability of the connection of the through hole, based on the photoforming method.

Now, Examples of the present invention will be described below:

Example 1

An adhesive having the following composition was applied to both sides of a paper-epoxy type laminated board, and heated at 110°C for 20 minutes and then at 170°C for further 40 minutes for hardening, whereby an adhesive hardened layer having a thickness of about 40 microns was formed. Then, a pass-through bore which constitutes a through hole was formed.

Composition of the adhesive:

| | |
|---|---|
| Nitrile rubber: A methylethyl ketone solution containing 20% by weight of Hycar 1072 (Trade name, produced by Nippon Zeon Co., Ltd.) | 250 parts by weight |
| Phenol resin: A methanol solution containing 50% by weight of Nikanol PR-1440M (Trade name, produced by Mitsubishi Gas Chemical Company, Inc.) | 50 parts by weight |
| Epoxy resin: A methylethyl ketone solution containing 80% by weight of Epicoat 1001 (Trade name, produced by Shell Petrochemical Co., Ltd.) | 31 parts by weight |
| Acid anhydride type hardener: A butyl cellosolve solution containing 20% by weight of Kayahard CLA (Trade name, produced by Nippon Kayaku Co., Ltd.) | 13 parts by weight |
| Silica powder: (Trade name #200, produced by Nippon Aerozil Co., Ltd.) | 10 parts by weight |

The substrate formed with the above adhesive layer was immersed in an oxidizing agent solution comprising 75 g/l of chromic acid anhydride, 300 ml/l of concentrated sulfuric acid, the rest being water, for 15 minutes, whereby the entire surface was roughened by the oxidizing treatment. After this oxidizing treatment, the substrate was washed with water, and further immersed in a 3% sodium persulfite solution to neutralize the excess amount of chromium.

On the other hand, 10 parts by weight of a light sensitive titanium oxide (Trade name Tipaque W-10, produced by Ishihara Sangyo Kaisha, Ltd.), 1.5 parts by weight of a surface active agent (Trade name Nikkol OP-10, produced by Nikko Chemicals K.K.) and 100 parts by weight of water were introduced into a ball mill and mixed for 24 hours for dispersion. The aqueous dispersion of the light sensitive titanium oxide thus obtained was diluted 10 times with water, and the above neutralized insulating substrate was immersed in the diluted dispersion and dried to deposit fine particles of the light sensitive titanium oxide on the entire surface, and thereafter it was immersed in a light sensitive solution having the following composition, and then dried to form a light sensitive material layer.

Composition of the light sensitive solution:

| | |
|---|---|
| Copper acetate | 8 g/l |
| Anthraquinone-2,6-disulfonic acid disodium salts | 16 g/l |
| Glycerin | 16 g/l |
| Sorbitol | 120 g/l |
| Pentaerythritol | 10 g/l |
| Water | rest |

A negative film was intimately overlaid on the light sensitive material layer thus provided, and a

ultraviolet ray (Strength: 30 mW/cm²) was radiated for 60 minutes. After washing with running water for from 30 to 60 seconds, the substrate was immersed in a non-electrolytic copper plating solution (pH 12.3, 60°C) having the following composition for 13 hours, whereby a printed circuit board having a conductor circuit layer having a thickness of 35 microns was obtained. Conduction resistance at the through hole was 0.3 m$\Omega$/hole or less, thereby giving also a practical sufficiency for good solderability. The through hole was observed by a cross section method, whereby no plating voids were found on the inner wall of the through hole and the plated state was satisfactory.

Composition of the non-electrolytic copper plating solution:

| | |
|---|---|
| Copper sulfate | 0.04 mol/l |
| EDTA | 0.10 mol/l |
| Formaldehyde | 0.30 mol/l |
| Potassium cyanide | 5 mg/l |
| Dipyridyl | 10 mg/l |
| Acetynol* | 50 mg/l |
| Sodium hydroxide | to adjust the pH to 12.3 |

*Nonionic surface active agent, produced by Nippon Surfactant K.K.

Comparative Example 1

A printed circuit board with a conductor circuit layer having a thickness of 35 microns was prepared in the same manner as Example 1 except that the step of depositing fine particles of the light sensitive titanium oxide on the substrate was omitted. Conduction resistance at the through hole was $10^3 \Omega$ or more, and the state of breaking was suggested. The through hole was observed by the cross section method, whereby numerous plating voids were observed on the inner wall surface of the through hole, and it was found that these plating voids caused the breaking.

Example 2

A printed circuit board was prepared in the same manner as in Example 1 except that the following light sensitive solution composition was used. There was no plating void observed on the inner wall of the through hole, and it had a superior dependability of the connection of the through hole.

Composition of the light sensitive solution:

| | |
|---|---|
| Palladium chloride | 2 g |
| Hydrochloric acid (35%) | 20 ml |
| Anthraquinone-2,6-disulfonic acid disodium salts | 8 g |
| Sorbitol | 120 g |
| n-Butanol | 50 ml |
| Water | 950 ml |

Comparative Example 2

A printed circuit board was prepared in the same manner as in Example 2 except that the step of depositing fine particles of the light sensitive titanium oxide on the substrate was omitted. Conduction resistance was $10^3 \Omega$ or more, resulting in bad connection. The through hole was observed by the cross section method, whereby numerous plating voids were observed on the inner surface of the through hole.

Example 3

A printed circuit board was prepared in the same manner as in Example 1 except that aqueous dispersion of light sensitive zinc oxide as specified in the following was employed in place of the aqueous dispersion of light sensitive titanium oxide.

Introduced into a ball mill were 10 parts by weight of zinc oxide (Trade name: Sazex 1000, produced by Sakai Chemical Industry Co., Ltd.), 1.5 parts by weight of the same surface active agent as used in Example 1 and 100 parts by weight of water, which were mixed for 24 hours for dispersion. The aqueous dispersion thus obtained was diluted 10 times with water.

Conduction resistance at the through hole of the printed circuit board was 0.3 m$\Omega$/hole or less, thereby giving a practical sufficiency for good solderability. The through hole was observed by a cross section method, and it was found that the whole inner wall of the through hole was filmed with copper plating.

**Claims**

1. A process for producing a printed circuit board, comprising:
step (A) of providing an adhesive layer on one side or both sides of an insulating substrate;
step (B) of roughening, and imparting a hydrophilic property to, the surface of said adhesive layer by a physical or chemical method;
step (D) of forming on the substrate a light sensitive material layer containing a metal in a reducible oxidized state capable of forming catalytic nuclei for non-electrolytic plating, and a light sensitive reducing agent;

step (E) of reductively precipitating metal particles constituting catalytic nuclei by selectively exposing said light sensitive material layer; and

step (F) of forming a conductive circuit layer by non-electrolytic plating after removing non-exposed portions of said light sensitive material layer;

wherein the improvement comprises providing, between the step (B) and the step (D), a step (C) of depositing fine particles of a light sensitive metal oxide semiconductor at least on the inner wall surface of a through hole.

2. A process according to Claim 1, wherein said light sensitive metal oxide semiconductor is selected from the group consisting of titanium dioxide, zinc oxide, tin dioxide and silicon oxide.

3. A process according to Claim 1, wherein said light sensitive metal oxide semiconductor is titanium dioxide.

4. A process according to Claim 1, wherein the particles of said semiconductor are deposited on the inner wall of the through hole by immersing the entire substrate into a suspension in which the semiconductor powder is dispersed in an amount of from 0.5 to 5 parts by weight in 100 parts by weight of water and drying the same.

5. A process according to Claim 4, wherein the semiconductor powder having a particle size of 0.03 to 0.5 μm is employed.

**Patentansprüche**

1. Verfahren zur Herstellung einer gedruckten Schaltungsplatte mit den folgenden Schritten:

Schritt (A) Vorsehen einer klebenden Schicht auf einer oder beiden Seiten eines isolierenden Substrats;

Schritt (B) Aufrauhen und Verleihen einer hydrophilen Eigenschaft einer Oberfläche der klebenden Schicht durch eine physikalische oder chemische Methode;

Schritt (D) Bilden auf dem Substrat einer lichtempfindlichen Materialschicht, enthaltend ein in einem reduzierbaren oxidierenden Zustand befindliches Metall, das zum Bilden katalytischer Kerne zur nichtelektrolytischen Plattierung fähig ist, und ein lichtempfindliches Reduktionsmittel;

Schritt (E) reduzierendes Ausfällen von Metallteilchen aus katalytischen Kernen durch selektives Belichten der lichtempfindlichen Materialschicht; und

Schritt (F) Bilden einer leitfähigen Schaltungsschicht durch nichtelektrolytisches Plattieren nach Entfernen nichtbelichteter Teile der lichtempfindlichen Materialshicht;

dadurch gekennzeichnet, daß zwischen dem Schritt (B) und dem Schritt (D) ein Schritt (C) Abscheiden feiner Teilchen eines lichtempfindlichen Metalloxidhalbleiters zumindest an der inneren Wandoberfläche eines Durchgangsloches vorgesehen ist.

2. Verfahren nach Anspruch 1, dadurch gekennzeichnet, daß der lichtempfindliche Metalloxidhalbleiter aus der Gruppe enthaltend Titandioxid, Zinkoxid, Zinndioxid und Siliziumoxid ausgewählt ist.

3. Verfahren nach Anspruch 1, dadurch gekennzeichnet, daß der lichtempfindliche Metalloxidhalbleiter Titandioxid ist.

4. Verfahren nach Anspruch 1, dadurch gekennzeichnet, daß die Teilchen des Halbleiters an der inneren Wand des Durchgangsloches durch Eintauchen des gesamten Substrats in eine Suspension abgeschieden werden, in welcher das Halbleiterpulver in einer Menge von 0,5 bis 5 Gewichtsteilchen in 100 Gewichtsteilchen Wasser dispergiert ist, und Trocknen derselben.

5. Verfahren nach Anspruch 4, dadurch gekennzeichnet, daß das Halbleiterpulver mit einer Teilchengröße von 0,03 bis 0,5 μm verwendet wird.

**Revendications**

1. Procédé de production d'une plaquette de circuit imprimé, qui comprend:

(A) un stade consistant à établir une couche adhésive sur une face ou les deux faces d'un substrat isolant;

(B) un stade où l'on rend rugeueuse la surface de ladite couche adhésive et on lui confère une propriété hydrophile, par une technique physique ou chimique;

(D) un stade consistant à former sur le substrat une couche de matière photosensible contenant un métal dans un état oxydé réductible, capable de former des germes catalytiques pour le placage non électrolytique, et un agent réducteur photosensible;

(E) un stade consistant à précipiter par réduction les particules métalliques constituant les germes catalytiques, par exposition sélective de ladite couche de matière photosensible; et

(F) un stade de formation d'une couche de circuit conducteur par placage non électrolytique après enlèvement des portions non exposées de ladite couche de matière photosensible;

dans lequel le perfectionnement consiste à introduire, entre le stade (B) et le stade (D), un stade (C) de dépôt de fines particules d'un oxyde métallique semiconducteur photosensible sur au moins la surface de la paroi interne d'un trou traversant.

6

2. Procédé selon la revendication 1, dans lequel ledit oxyde métallique semiconducteur photosensible est choisi dans le groupe comprenant le bioxyde de titane, l'oxyde de zinc, le bioxyde d'étain et l'oxyde de silicium.

3. Procédé selon la revendication 1, dans lequel ledit oxyde métallique semiconducteur photosensible est le bioxyde de titane.

4. Procédé selon la revendication 1, dans lequel les particules dudit semiconducteur sont déposées sur la paroi interne du trou traversant par immersion du substrat tout entier dans une suspension dans laquelle la poudre de semiconducteur est dispersée à raison de 0,5 à 5 parties en poids dans 100 parties en poids d'eau, et séchage ultérieur du substrat.

5. Procédé selon la revendication 4, dans lequel on utilisé une poudre de semiconducteur ayant une granulométrie de 0,03 à 0,5 µm.